# EUROPEAN PATENT SPECIFICATION

(11) **EP 4 167 052 B1**
(45) Date of publication and mention of the grant of the patent: **07.05.2025**
(21) Application number: 22201646.1
(22) Date of filing: 14.10.2022
(51) Int. Cl.: G06F 1/16, H01L 25/075, H01L 33/62

(54) **DISPLAY DEVICE**
ANZEIGEVORRICHTUNG
DISPOSITIF D'AFFICHAGE

(30) Priority: 14.10.2021 KR 20210136965
(43) Date of publication of application: 19.04.2023
(73) Proprietor: Samsung Display Co., Ltd., Yongin-si, Gyeonggi-do 17113 (KR)
(72) Inventor: YUN, Hae Ju, 17113 Yongin-si (KR); MOON, Soo Hyun, 17113 Yongin-si (KR); MIN, Jun Seok, 17113 Yongin-si (KR); JANG, Woo Guen, 17113 Yongin-si (KR)
(74) Representative: Walaski, Jan Filip

(56) References cited:
- EP-A1- 3 855 495
- US-A1- 2015 280 154
- US-A1- 2019 206 979
- US-A1- 2021 014 982
- US-A1- 2021 143 360
- US-A1- 2021 167 328
- US-A1- 2021 217 739

## Description

### CROSS-REFERENCE TO RELATED APPLICATION(S)

This application claims priority to Korean Patent Application No. 10-2021-0136965, filed in the Korean Intellectual Property Office (KIPO) on October 14, 2021.

### BACKGROUND

### 1. Technical Field

The disclosure relates to a display device, and more particularly, to a display device that includes a rollable display panel.

### 2. Description of the Related Art

As an interest in an information display largely increases and a demand for using a portable information medium increases, a demand and commercialization for a display device has been progressed in priority.
US 2019/206979 A1 discloses an electroluminescent display device capable of overcoming a problem related with a resistance of a low level voltage line.
US 2015/280154 A1 discloses a flexible display panel.
US 2021/143360 A1 discloses a display device.

### SUMMARY

The disclosure has been made in an effort to provide a display device that may prevent static electricity.

According to an aspect of the invention, there is provided a display device as set out in claim 1.

The conductive pattern may include a transparent electrode material.

The conductive pattern may include a conductive polymer material.

The display device may further include a black matrix pattern disposed between the pixels in the display area, wherein the conductive pattern may overlap the black matrix pattern in a plan view.

The housing may include a housing groove accommodating the display panel, and the display panel is a rollable display panel.

The display panel may further include a first pad electrode overlapping the at least one hole in the non-display area in a plan view; a second pad electrode disposed on the first pad electrode and electrically contacting the first pad electrode; and a third pad electrode disposed on the second pad electrode and electrically contacting the second pad electrode, and the conductive pattern may electrically contacting the third pad electrode.

The display device may further include a connection member disposed on a surface of the first pad electrode in the at least one hole and electrically connecting the conductive pattern and the housing.

The connection member may be a paste including a conductive material.

Another embodiment provides a display device including a base layer that includes a display area displaying an image and a non-display area including at least one hole; pixels that are dispersed and disposed in the display area; and a conductive pattern disposed between the pixels in the display area and overlapping the at least one hole in a plan view, and wherein the conductive pattern has a shape corresponding to a disposition shape of the pixels.

The pixels may be disposed to be spaced apart from each other in a matrix format, and the conductive pattern may have a mesh shape surrounding each of the pixels.

The pixels may be disposed to be spaced apart from each other in a matrix format, and the conductive pattern may surround two or more of the pixels.

Pad parts may be disposed in the non-display area, and the at least one hole may be respectively formed between the pad parts.

The display device may further include a black matrix pattern disposed between the pixels in the display area and overlapping the conductive pattern in a plan view.

The conductive pattern may include a transparent electrode material.

The conductive pattern may include a conductive polymer material.

Another embodiment provides a display device including a base layer that includes a display area displaying an image and a non-display area including at least one hole; a color conversion layer disposed on the base layer in the display area and including at least one type of color conversion particle; a black matrix pattern disposed at both sides of the color conversion layer; and a conductive pattern disposed on the black matrix pattern so as to overlap the black matrix pattern in a plan view, wherein in the non-display area, the conductive pattern overlaps the at least one hole in a plan view.

The display device may further include a planarization layer covering the color conversion layer and the conductive pattern; and a color filter layer disposed on the planarization layer and including a color filter corresponding to a color of the color conversion particle.

The display device may further include an upper substrate disposed on the color filter layer.

The conductive pattern may include a transparent electrode material.

The conductive pattern may include a conductive polymer material.

According to the embodiment, it is possible to provide a display device that may prevent static electricity in a display panel by disposing a conductive pattern on the display panel and connecting the conductive pattern to a housing through a hole in a non-display area.

In addition, it is possible to improve the quality of a display device.

Effects of the embodiment are not limited by what is illustrated in the above, and more various effects are included in the specification.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 schematically illustrates a display device according to an embodiment.
FIG. 2 schematically illustrates a display panel according to an embodiment.
FIG. 3 schematically illustrates a cross-sectional view taken along line III-III' of FIG. 2.
FIG. 4 schematically illustrates a state in which a display panel and a housing are connected to each other according to an embodiment.
FIG. 5 schematically illustrates a state in which a display panel according to an embodiment is wound around a housing.
FIG. 6 schematically illustrates an enlarged cross-sectional view of area "VI" of FIG. 5.
FIG. 7 schematically illustrates a schematic diagram of equivalent circuit of one pixel of a display device according to an embodiment.
FIG. 8 schematically illustrates a perspective view of a light emitting element according to an embodiment.
FIG. 9 schematically illustrates an example of a pixel included in a display device according to an embodiment.
FIG. 10 schematically illustrates an example of a pixel according to an embodiment.
FIG. 11 to FIG. 13 schematically illustrate a display panel according to an embodiment.
FIG. 14 to FIG. 16 schematically illustrate examples of a pixel according to an embodiment.

### DETAILED DESCRIPTION OF THE EMBODIMENTS

Since the disclosure may be variously modified and have various forms, embodiments will be illustrated and described in detail in the following. This, however, by no means restricts the disclosure to the specific embodiments, and it is to be understood as embracing all included in the scope of the invention as defined by the claims.

Terms such as first, second, and the like will be used only to describe various constituent elements, and are not to be interpreted as limiting these constituent elements. The terms are only used to differentiate one constituent element from other constituent elements. For example, a first constituent element could be termed a second constituent element, and similarly, a second constituent element could be termed as a first constituent element, without departing from the scope of the disclosure. Singular forms are intended to include plural forms (or meanings) unless the context clearly indicates otherwise.

In the disclosure, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance. It will be understood that when an element such as a layer, film, region, area, or substrate is referred to as being "on" another element, it can be directly on the other element or intervening elements may also be present. In addition, in the specification, when a portion of a layer, film, region, area, plate, or the like is referred to as being formed "on" another portion, the formed direction is not limited to an upper direction but includes a lateral or lower direction. In contrast, when an element of a layer, film, region, area, plate, or the like is referred to as being "below" another element, it may be directly below the other element, or intervening elements may be present.

Hereinafter, a display device according to an embodiment of the disclosure will be described with reference to drawings related to the embodiment.

The term "overlap" or "at least partially overlap" as used herein may mean that at least part of a first object faces at least part of a second object in a given direction or given view.

It will be understood that the terms "contact," "connected to," and "coupled to" may include a physical and/or electrical contact, connection, or coupling.

The phrase "at least one of" is intended to include the meaning of "at least one selected from the group of' for the purpose of its meaning and interpretation. For example, "at least one of A and B" may be understood to mean "A, B, or A and B."

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

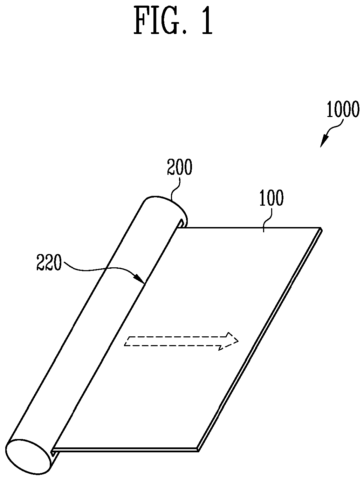

FIG. 1 illustrates a display device according to an embodiment.

Referring to FIG. 1, a display device 1000 according to an embodiment includes a display panel 100 and a housing 200 accommodating the display panel 100. The display panel 100 may be in a form wound with a curvature (e.g., a predetermined or selected curvature) in the housing 200. For example, the display panel 100 according to the embodiment is a rollable display panel.

The display panel 100 may be realized as a self-light emitting display panel such as a flexible organic light emitting display (OLED) panel, a flexible nano-scale light-emitting diode (LED) display panel, and a flexible quantum dot organic light emitting display (QD OLED) panel.

In case that a power source is applied to the display device 1000 or a display function operates, the display panel 100 wound on a roller inside the housing 200 may be exposed to the outside of the housing 200 while sliding in a direction indicated by a dotted line by rotation of the roller. In addition, in case that no power source is applied to the display device 1000 or no display function operates, the display panel 100 may be wound inside the housing 200 while sliding in a direction opposite to the direction indicated by the dotted line by the rotation of the roller.

The display panel 100 may slide while moving in left and right directions along a housing groove 220. The housing groove 220 may be implemented or provided to fit a horizontal (or width) length of the display panel 100.

Although FIG. 1 illustrates that the housing 200 has a cylindrical shape, the shape of the housing 200 is not limited thereto, and may be variously modified.

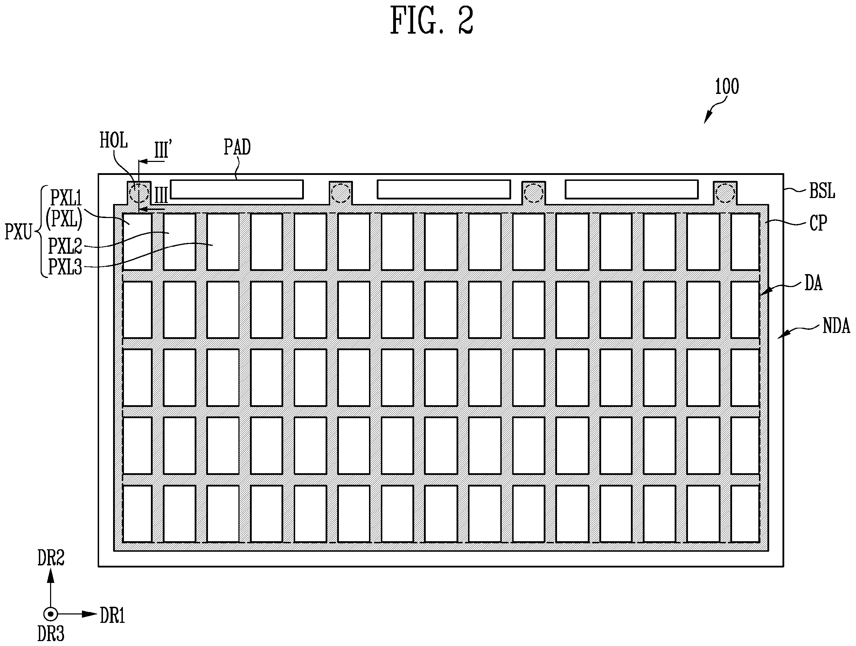

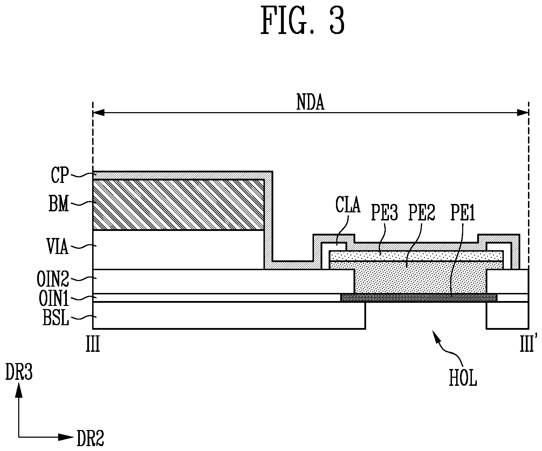

Hereinafter, a display panel according to an embodiment will be described in detail with reference to FIGS. 2 and 3.

FIG. 2 illustrates a display panel according to an embodiment, and FIG. 3 illustrates a schematic cross-sectional view taken along line III-III' of FIG. 2.

Referring to FIG. 2, the display panel 100 according to the embodiment includes a base layer BSL, and pixels PXL and a conductive pattern CP that are disposed on the base layer BSL.

The base layer BSL may form a base member of the display panel 100. In some embodiments, the base layer BSL may be a rigid or flexible substrate or film, and its material or physical properties are not particularly limited. For example, the base layer BSL may be formed as a rigid substrate made of glass or tempered glass, as a flexible substrate (or a thin film) made of a plastic or metallic material, or as at least one layer of insulation film, but its material and/or physical properties are not particularly limited.

The base layer BSL includes a display area DA displaying an image and a non-display area NDA excluding the display area DA. The non-display area NDA is an area in which no image is displayed, and may be a bezel area surrounding the display area DA.

The pixels PXL are dispersed and disposed in the display area DA. For example, the pixels PXL may be disposed in the display area DA to have an arrangement structure such as a matrix or stripe. However, the disclosure is not limited thereto.

A pixel part PXU may include a first pixel PXL1, a second pixel PXL2, and a third pixel PXL3, and the first to third pixels PXL1, PXL2, and PXL3 may emit respective different colors of light. A black matrix pattern may be positioned between the first to third pixels PXL1, PXL2, and PXL3.

The non-display area NDA is disposed around the display area DA to surround the display area DA. Wires, pad parts PAD, a driving circuit, and the like, which are electrically connected to the pixels PXL of the display area DA, may be disposed in the non-display area NDA. In addition, in the non-display area NDA, at least one hole HOL that may be electrically connected to the conductive pattern CP to be described later may be defined.

The pixels PXL in the display area DA may be electrically connected to a driving circuit for driving the pixels PXL through the pad parts PAD and/or signal wires.

The driving circuit may include a gate driving circuit for applying a scan signal to the pixels PXL through a gate line and a data driving circuit for applying a data voltage to the pixels PXL through a data line. The gate driving circuit and the data driving circuit may be implemented with thin-film transistors in the non-display area NDA. In addition, a driving integrated circuit including the gate driving circuit or data driving circuit is mounted on a separate printed circuit board, and may be electrically connected to an interface disposed in the non-display area NDA through a circuit film such as a flexible printed circuit board (FPCB), a chip on film (COF), or a tape carrier package (TCP).

The display panel 100 may include various additional elements for generating various signals or driving the pixels PXL in the display area DA. The additional elements may include an inverter circuit, a multiplexer, an electrostatic discharge circuit, and the like.

The conductive pattern CP may be positioned in the display area DA and the non-display area NDA. The conductive pattern CP may be positioned to surround an outer portion of the display area DA in the non-display area NDA, and may be positioned between the pixels PXL in the display area DA.

A black matrix pattern may exist between the pixels PXL, and the pixels PXL may be positioned to be spaced apart from each other. The conductive pattern CP may be positioned to at least partially overlap the black matrix pattern (e.g., in a plan view or in the third direction DR3). Although not shown in FIG. 2, the black matrix pattern may be positioned under the conductive pattern CP disposed in the display area DA. For example, the conductive pattern CP according to the embodiment may entirely overlap the black matrix pattern in the display area DA.

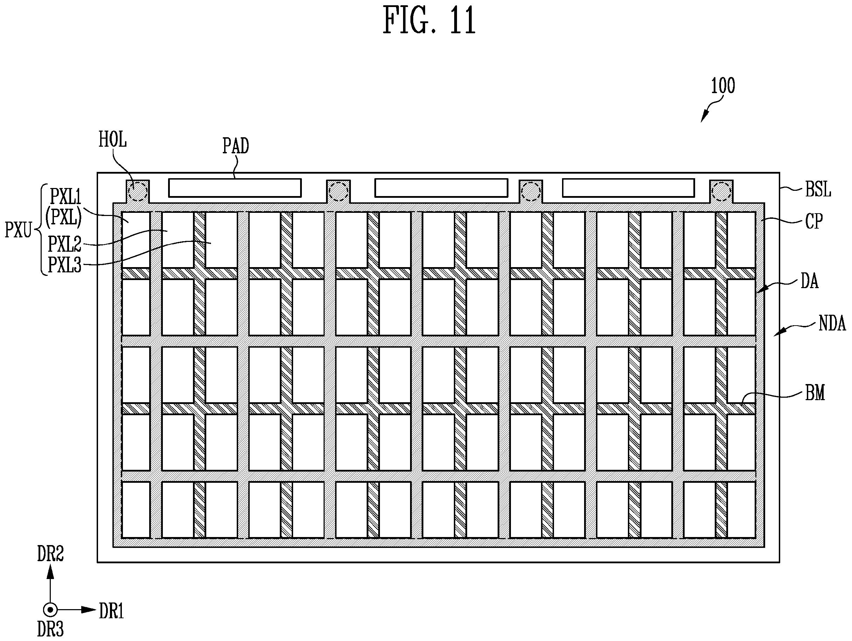

In the embodiment, the conductive pattern CP may have a mesh shape surrounding all of the pixels PXL. However, the disclosure is not limited thereto, and the conductive pattern CP may have various shapes depending on the arrangement of the pixels PXL, an area overlapping the black matrix pattern, and the like. Various shapes of the conductive pattern CP will be described with reference to FIGS. 11 to 13 to be described below.

The conductive pattern CP may be positioned in a portion of the non-display area NDA, and may be positioned to overlap at least one hole HOL positioned between the pad parts PAD of the non-display area NDA. Each of the pad parts PAD may be physically and/or electrically connected to a driving integrated circuit, and at least one hole HOL may be electrically connected to the housing 200 through a connection member.

The conductive pattern CP is electrically connected to the housing 200 through at least one hole HOL. Specifically, the conductive pattern CP may be physically and/or electrically connected to the housing 200 (for example, a rolling jig) through a connection member positioned in at least one hole HOL.

In a display device including a rollable display panel according to a comparative example, static electricity may occur from an upper portion of the display panel during manufacturing or moving of the panel. In this case, the static electricity flows to the light emitting element and transistor of the display panel, which may affect an operation of the display panel.

The display device according to the embodiment has the conductive pattern CP that is disposed in the display area DA and the non-display area NDA of the display panel 100 and is electrically connected to the housing 200 through at least one hole HOL of the non-display area NDA, to induce (or guide), toward the outside, static electricity that may occur from the upper portion of the display panel 100, thereby preventing static electricity on the display panel 100. Accordingly, the display device according to the embodiment may improve the quality of the display panel 100.

The conductive pattern CP may include a transparent electrode material. For example, the conductive pattern CP may include a transparent conductive oxide such as an indium tin oxide (ITO), an indium zinc oxide (IZO), a zinc oxide (ZnO), an indium gallium zinc oxide (IGZO), and an indium tin zinc oxide (ITZO), but the disclosure is not limited thereto.

The conductive pattern CP may include a conductive polymer material. For example, the conductive pattern CP may include a conductive polymer such as polyacetylene, polypyrrole, polythiophene, poly(3,4-ethylenedioxythiophene) (PEDOT), or polyaniline, but the disclosure is not limited thereto.

Referring to FIG. 3, the display panel 100 according to the embodiment may include a base layer BSL, a first outer insulation layer OIN1, a first pad electrode PE1, a second outer insulation layer OIN2, a via layer VIA, a black matrix pattern BM, a second pad electrode PE2, a third pad electrode PE3, a cladding layer CLA, and a conductive pattern CP.

The base layer BSL may include a hole HOL exposing a surface of the first pad electrode PE1, which will be described below. For example, when viewed in a third direction DR3, a lower surface of the first pad electrode PE1 may be exposed by the hole HOL of the base layer BSL.

The first outer insulation layer OIN1 may be positioned on the base layer BSL. The first outer insulation layer OIN1 may be an inorganic insulation film including an inorganic material. For example, the first outer insulation layer OIN1 may include at least one of metal oxides such as a silicon nitride (SiNₓ), a silicon oxide (SiOₓ), a silicon oxynitride (SiOₓN_{y}), and an aluminum oxide (AlOₓ). In some embodiments, the first outer insulation layer OIN1, a gate insulation layer, and an interlayer insulation layer disposed in the display area DA may include a same material, and may be formed by a same process.

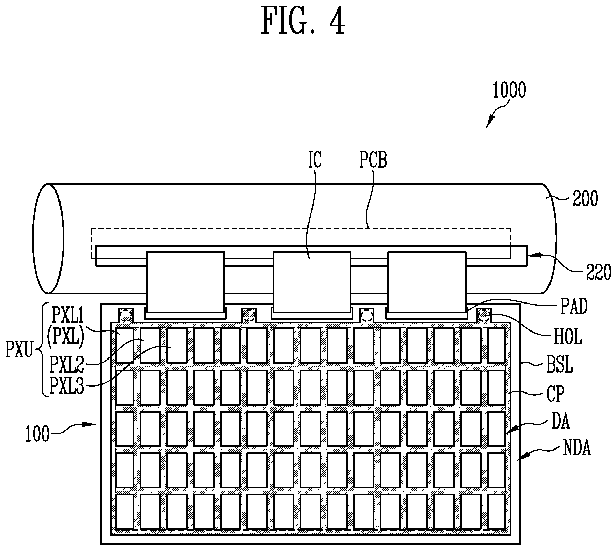

The first pad electrode PE1 may be positioned on the base layer BSL. Specifically, the first pad electrode PE1 may overlap the hole HOL of the base layer BSL and at least partially overlap portions of the base layer BSL spaced apart from each other with the hole HOL therebetween. In the embodiment, a lower surface of the first pad electrode PE1 exposed by the hole HOL may be physically and/or electrically connected to the housing 200 (see FIG. 1) by a connection member. A connection relationship between the housing 200 and the display panel 100 will be described in detail with reference to FIGS. 4 to 6 to be described below.

The first pad electrode PE1 and the first outer insulation layer OIN1 may be positioned on a same layer. FIG. 3 illustrates that a thickness of the first pad electrode PE1 and a thickness of the first outer insulation layer OIN1 are the same, but the disclosure is not limited thereto. In some embodiments, the first outer insulation layer OIN1 may be positioned to cover (or overlap, e.g., in a plan view) a portion of the first pad electrode PE1.

The second outer insulation layer OIN2 may be positioned on the first outer insulation layer OIN1 and the first pad electrode PE1. The second outer insulation layer OIN2 may entirely overlap the first outer insulation layer OIN1, and may at least partially overlap the first pad electrode PE1 to expose an upper surface of the first pad electrode PE1.

The second outer insulation layer OIN2 may include an inorganic insulation film and/or an organic insulation film. The inorganic insulation film may include at least one of metal oxides such as a silicon oxide (SiOₓ), a silicon nitride (SiNₓ), a silicon oxynitride (SiOₓN_{y}), an aluminum oxide (AlOₓ). The organic insulation film may be at least one of a polyacrylates resin, an epoxy resin, a phenolic resin, a polyamides resin, a polyimides resin, an unsaturated polyesters resin, a polyphenylene ethers resin, a polyphenylene sulfides resin, and a benzocyclobutene resin. In some embodiments, the second outer insulation layer OIN2 and a passivation layer and the like disposed in the display area DA may include a same material, and may be formed by a same process.

The via layer VIA may be positioned on the second outer insulation layer OIN2. The via layer VIA may at least partially overlap the second outer insulation layer OIN2 (e.g., in a plan view), and may expose an upper surface of the second outer insulation layer OIN2.

The via layer VIA may include an organic insulation film. For example, the organic insulation film may include at least one of a polyacrylates resin, an epoxy resin, a phenolic resin, a polyamides resin, a polyimides rein, an unsaturated polyesters resin, a polyphenylene ethers resin, a polyphenylene sulfides resin, and a benzocyclobutene resin. In some embodiments, the via layer VIA and a via layer disposed in the display area DA may include a same material, and may be formed by a same process.

The black matrix pattern BM may be positioned on the via layer VIA. The black matrix pattern BM may be a portion in which a black matrix pattern of the display area DA extends.

The second pad electrode PE2 may be positioned on the first pad electrode PE1, and may be positioned on the second outer insulation layer OIN2 to at least partially overlap the second outer insulation layer OIN2.

The second pad electrode PE2 may directly contact the first pad electrode PE1, so that the second pad electrode PE2 and the first pad electrode PE1 may be physically and/or electrically connected to each other. In some embodiments, the second pad electrode PE2, and at least one of a bottom metal layer, a gate electrode, a source electrode, and a drain electrode of the display area DA may include a same material, and may be formed by a same process.

The third pad electrode PE3 may be positioned on the second pad electrode PE2.

The third pad electrode PE3 may directly contact the second pad electrode PE2, so that the third pad electrode PE3 and the second pad electrode PE2 may be physically and/or electrically connected to each other. In some embodiments, the third pad electrode PE3 and an alignment electrode of the display area DA may include a same material, and may be formed by a same process.

The cladding layer CLA may be positioned at both edges of the third pad electrode PE3 and the second pad electrode PE2 to partially cover the third pad electrode PE3 and the second pad electrode PE2. The cladding layer CLA may include an inorganic insulation material. For example, the cladding layer CLA may include, for example, at least one of metal oxides such as a silicon oxide (SiOₓ), a silicon nitride (SiNₓ), a silicon oxynitride (SiOₓN_{y}), an aluminum oxide (AlOₓ).

In the non-display area NDA, the conductive pattern CP may be positioned on the black matrix pattern BM, the second outer insulation layer OIN2, the cladding layer CLA, and the third pad electrode PE3 so as to cover the black matrix pattern BM, the second outer insulation layer OIN2, the cladding layer CLA, and the third pad electrode PE3.

The conductive pattern CP may be positioned to at least partially overlap the black matrix pattern BM.

The conductive pattern CP may directly contact the third pad electrode PE3, so that the conductive pattern CP and the third pad electrode PE3 may be physically and/or electrically connected to each other. For example, the conductive pattern CP may be physically and/or electrically connected to the third pad electrode PE3, the second pad electrode PE2, and the first pad electrode PE1. Accordingly, the conductive pattern CP may induce static electricity that may be generated in the upper portion of the display panel 100, to the outside through the third pad electrode PE3, the second pad electrode PE2, and the first pad electrode PE1.

Hereinafter, a display panel electrically connected to a housing will be described in detail with reference to FIGS. 4 to 6.

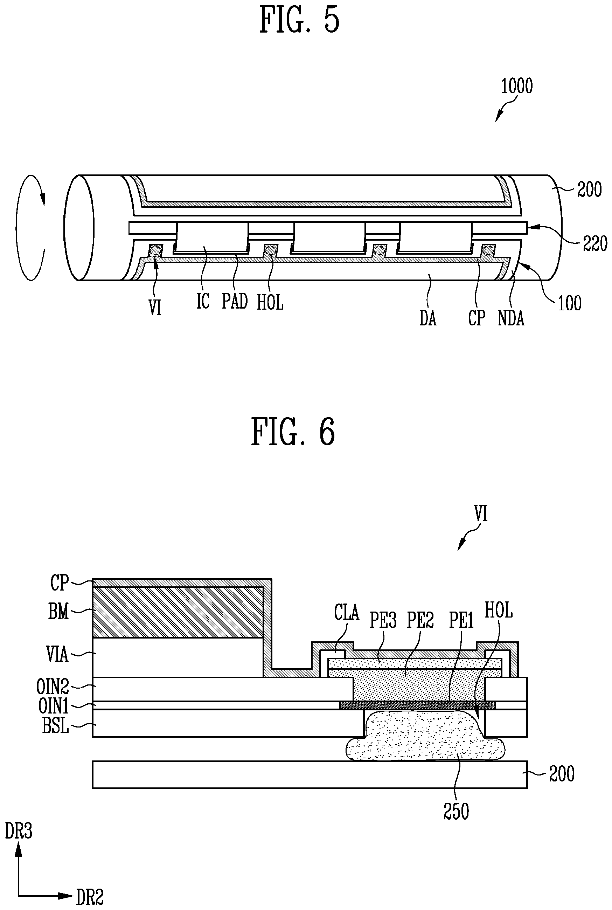

FIG. 4 illustrates a state in which a display panel and a housing are electrically connected to each other according to an embodiment, FIG. 5 illustrates a state in which a display panel according to an embodiment is wound around a housing, and FIG. 6 illustrates a schematic enlarged cross-sectional view of area "VI" of FIG. 5.

Referring to FIG. 4, by inserting a printed circuit board PCB into the housing groove 220, the housing 200 and the display panel 100 may be electrically connected. In the embodiment, after forming at least one hole HOL in the non-display area NDA of the display panel 100, the printed circuit board PCB may be inserted into the housing groove 220.

The pad part PAD of the display panel 100 may be attached to a driving integrated circuit IC to be physically and/or electrically connected thereto, and the driving integrated circuit IC may be attached to the printed circuit board PCB to be physically and/or electrically connected thereto. Accordingly, a scan signal, a data voltage, a driving voltage, and the like may be applied to the pixels PXL through the pad part PAD according to a signal, a voltage, and the like applied from the printed circuit board PCB.

Referring to FIG. 5, in the display device 1000 according to the embodiment, the display panel 100 may be wound along a surface of the housing 200 while the housing 200 rotates in an arrow direction shown in FIG. 5. An area of the display panel 100 (for example, an area overlapping a rolling jig) may contact the housing 200 to be fixed.

Referring to FIG. 6, a connection member 250 may be positioned between the display panel 100 and the housing 200.

The connection member 250 may be positioned on a surface (for example, a lower surface) of the first pad electrode PE1 in at least one hole HOL of the display panel 100, and may electrically connect the conductive pattern CP and the housing 200.

The connection member 250 may be a paste containing a conductive material. For example, the connection member 250 may include at least one conductive material of silver (Ag), gold (Au), copper (Cu), and nickel (Ni).

The display device according to the embodiment connects the conductive pattern CP to the housing 200 through at least one hole HOL of the non-display area NDA and the connection member 250, to induce static electricity that may be generated from the upper portion of the display panel 100 to the outside, so the static electricity on the display panel 100 may be prevented.

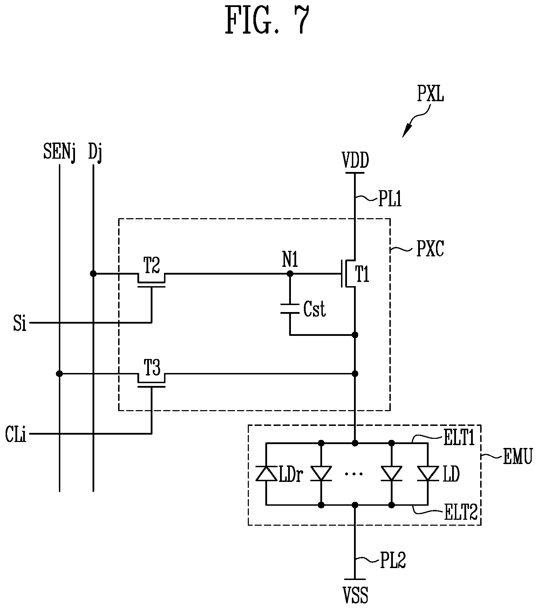

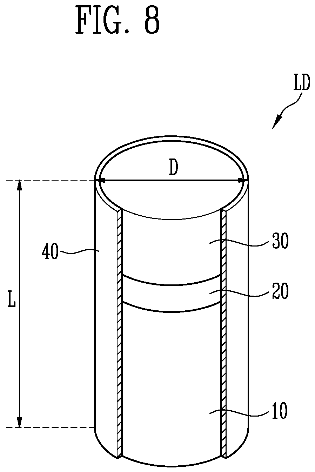

Hereinafter, a pixel and a light emitting element of a display device according to an embodiment will be described with reference to FIGS. 7 and 8.

FIG. 7 illustrates a schematic diagram of an equivalent circuit of a pixel of a display device according to an embodiment, and FIG. 8 illustrates a schematic perspective view of a light emitting element according to an embodiment.

Referring to FIG. 7, a pixel PXL may include at least one light emitting part EMU that generates light with luminance corresponding to a data signal. In addition, a pixel PXL may further selectively include a pixel circuit PXC for driving the light emitting part EMU.

The light emitting part EMU may include light emitting elements LD electrically connected in parallel between a first power line PL1 to which a voltage of a first driving power source VDD is applied and a second power line PL2 to which a voltage of a second driving power source VSS is applied.

Specifically, the light emitting part EMU may include a first pixel electrode ELT1 electrically connected to the first driving power source VDD via the pixel circuit PXC and the first power line PL1, a second pixel electrode ELT2 electrically connected to the second driving power source VSS through the second power line PL2, and a light emitting elements LD electrically connected to each other in parallel in a same direction between the first pixel electrode ELT1 and the second pixel electrode ELT2. In the embodiment, the first pixel electrode ELT1 may be an anode, and the second pixel electrode ELT2 may be a cathode.

Each of the light emitting elements LD included in the light emitting part EMU may include one end portion (or first end portion) electrically connected to the first driving power source VDD through the first pixel electrode ELT1 and the other end portion (or second end portion) electrically connected to the second driving power source VSS through the second pixel electrode ELT2.

The first driving power source VDD and the second driving power source VSS may have different potentials. For example, the first driving power source VDD may be set as a high-potential power source, and the second driving power source VSS may be set as a low-potential power source. In this case, a potential difference between the first driving power source VDD and the second driving power source VSS may be set to be equal to or higher than a threshold voltage of the light emitting elements LD during a light emitting period of the pixel PXL.

As described above, respective light emitting elements LD electrically connected to each other in parallel in a same direction (for example, a forward direction) between the first pixel electrode ELT1 and the second pixel electrode ELT2 respectively supplied with voltages of different potentials may form respective effective light sources. These effective light sources may collectively form the light emitting part EMU of the pixel PXL.

In some embodiments, the light emitting part EMU may further include at least one ineffective light source, for example, a reverse light emitting element LDr, in addition to the light emitting elements LD forming respective effective light sources. The reverse light emitting element LDr is electrically connected in parallel between the first and second pixel electrodes ELT1 and ELT2, but is electrically connected between the first and second pixel electrodes ELT1 and ELT2 in the opposite direction with respect to the light emitting elements LD. The reverse light emitting element LDr maintains an inactive state even in case that a driving voltage (e.g., a predetermined or selected driving voltage (for example, a driving voltage in a forward direction) is applied between the first and second pixel electrodes ELT1 and ELT2, and thus a current does not substantially flow in the reverse light emitting element LDr.

The light emitting elements LD of the light emitting part EMU may emit light with luminance corresponding to a driving current supplied thereto through the pixel circuit PXC. For example, during each frame period, the pixel circuit PXC may supply a driving current, corresponding to a grayscale value of data of a frame, to the light emitting part EMU. The driving current supplied to the light emitting part EMU may be divided and flow in each of the light emitting elements LD. Therefore, while each light emitting element LD emits light with a luminance corresponding to the current flowing therein, the light emitting part EMU may emit light having a luminance corresponding to the driving current.

FIG. 7 illustrates the embodiment in which the light emitting elements LD forming the light emitting part EMU are all electrically connected in parallel, but the disclosure is not limited thereto.

The pixel circuit PXC is electrically connected to a scan line Si and a data line Dj of a pixel PXL. For example, in case that the pixel PXL is disposed in an i-th row (where i is a natural number) and a j-th column (where j is a natural number) of the display area DA, the pixel circuit PXC of the pixel PXL may be electrically connected to an i-th scan line Si and a j-th data line Dj of the display area DA. In addition, the pixel circuit PXC may be electrically connected to an i-th control line CLi and a j-th sensing line SENj of the display area DA.

The pixel circuit PXC may include a first transistor T1, a second transistor T2, a third transistor T3, and a storage capacitor Cst.

A first terminal of the first transistor T1 (or driving transistor) is electrically connected to the first driving power supply source VDD, and a second terminal thereof is electrically connected to a first pixel electrode ELT1. A gate electrode of the first transistor T1 is electrically connected to a first node N1. Accordingly, the first transistor T1 may control an amount of driving current supplied to the light emitting elements LD in response to a voltage of the first node N1.

A first terminal of the second transistor T2 (or switching transistor) is electrically connected to the data line Dj, and a second terminal thereof is electrically connected to the first node N1. A gate electrode of the second transistor T2 is electrically connected to the scan line Si. The second transistor T2 is turned on in case that a scan signal (high level) having a turn-on voltage is supplied from the scan line Si, and electrically connects the data line Dj and the first node N1. In this case, in case that a data signal of a frame is supplied to the data line Dj, the data signal is transmitted to the first node N1. The data signal transmitted to the first node N1 is charged in the storage capacitor Cst.

The third transistor T3 is electrically connected between the first transistor T1 and the sensing line SENj. Specifically, a first terminal of the third transistor T3 is electrically connected to the first terminal of the first transistor T1, and a second terminal of the third transistor T3 is electrically connected to the sensing line SENj. A gate electrode of the third transistor T3 is electrically connected to the control line CLi. The third transistor T3 is turned on by a control signal (high level) having a gate-on voltage supplied to the control line CLi during a sensing period to electrically connect the sensing line SENj to the first transistor T1. The sensing period may be a period for extracting characteristic information (for example, a threshold voltage of the first transistor T1) of each of the pixels PXL disposed in the display area DA.

One electrode of the storage capacitor Cst is electrically connected to the first node N1, and the other electrode thereof is electrically connected to the second terminal of the first transistor T1. The storage capacitor Cst may be charged with a voltage corresponding to a voltage difference between a voltage corresponding to a data signal supplied to the first node N1 and a voltage of the second terminal of the first transistor T1, and it may maintain the charged voltage until a data signal of a subsequent frame is supplied.

FIG. 7 illustrates the embodiment in which all of the first to third transistors T1 to T3 are N-type transistors, but the disclosure is not limited thereto. In some embodiments, at least one of the first to third transistors T1 to T3 may be changed to a P-type transistor.

In addition, although FIG. 7 illustrates the embodiment in which the light emitting part EMU is electrically connected between the pixel circuit PXC and the second driving power source VSS, the light emitting part EMU may also be electrically connected between the first driving power source VDD and the pixel circuit PXC.

Referring to FIG. 8, a light emitting element LD included in a display device according to an embodiment may include a first semiconductor layer 10, a second semiconductor layer 30, and an active layer 20 disposed between the first semiconductor layer 10 and the second semiconductor layer 30. For example, the light emitting element LD may be configured of a stacked body in which the first semiconductor layer 10, the active layer 20, and the second semiconductor layer 30 are sequentially stacked in a length L direction.

The light emitting element LD may be provided to have a rod shape extending in a direction, for example, a cylindrical shape. In case that an extending direction of the light emitting element LD is referred to as a length L direction, the light emitting element LD may be provided with one end portion and the other end portion in the length L direction. FIG. 8 illustrates a light emitting element LD having a cylindrical shape, but the type and/or shape of the light emitting element according to the embodiment is not limited thereto.

The light emitting element LD may be an LED manufactured in a rod shape. In the specification, "rod shape" refers to a rod-like shape or bar-like shape (for example, having an aspect ratio of greater than 1) that is long in the length L direction, such as a circular cylinder or a polygonal cylinder, but a shape of a cross section thereof is not particularly limited.

The light emitting element LD may have a size to the degree of nano-scale or micro-scale. Each light emitting element LD may have a diameter D and/or the length L ranging from a nano-scale to a micro-scale. The size of the light emitting element LD may be variously changed according to design conditions of various devices using, as a light source, a light emitting device using the light emitting element LD, for example, a display device.

The first semiconductor layer 10 may include at least one n-type semiconductor layer. For example, the first semiconductor layer 10 may include at least one semiconductor material of InAlGaN, GaN, AlGaN, InGaN, AlN, and InN, and may include a n-type semiconductor layer doped with a first conductive dopant such as Si, Ge, Sn, or the like. However, the material included in the first semiconductor layer 10 is not limited thereto, and the first semiconductor layer 10 may be made of at least one material or various materials.

The active layer 20 is disposed on the first semiconductor layer 10, and may be formed to have a single or multi-quantum well structure. In the embodiment, a clad layer (not shown) doped with a conductive dopant may be formed at an upper portion and/or a lower portion of the active layer 20. For example, the clad layer may be formed as an AlGaN layer or an InAlGaN layer. In some embodiments, at least one material such as AlGaN and InAlGaN may be used to form the active layer 20, and in addition, at least one material or various materials may form the active layer 20.

In case that a voltage higher than or equal to a threshold voltage is applied to end portions of the light emitting element LD, the light emitting element LD emits light while electron-hole pairs are combined in the active layer 20. By controlling the light emission of the light emitting element LD by using this principle, the light emitting element LD may be used as a light source for various light emitting devices, including pixels of a display device.

The second semiconductor layer 30 is disposed to on the active layer 20, and may include a semiconductor layer of a type different from that of the first semiconductor layer 10. For example, the second semiconductor layer 30 may include at least one p-type semiconductor layer. For example, the second semiconductor layer 30 may include at least one semiconductor material of InAlGaN, GaN, AlGaN, InGaN, AlN, and InN, and may include a p-type semiconductor layer doped with a second conductive dopant such as Mg, Zn, Ca, Sr, or Ba. However, the material included in the second semiconductor layer 30 is not limited thereto, and the second semiconductor layer 30 may be formed of (or may include) at least one material or various materials.

In the above-described embodiment, it is described that each of the first semiconductor layer 10 and the second semiconductor layer 30 are formed as a layer, but the disclosure is not limited thereto. In the embodiment, each of the first semiconductor layer 10 and the second semiconductor layer 30 may further include one or more layers, for example, a cladding layer and/or a tensile strain barrier reducing (TSBR) layer according to the material of the active layer 20. The TSBR layer may be a strain reducing layer disposed between semiconductor layers having different lattice structures and serving as a buffer to reduce a difference in lattice constant. The TSBR layer may be formed of a p-type semiconductor layer such as p-GaInP, p-AlInP, or p-AlGaInP, but the disclosure is not limited thereto.

In some embodiments, the light emitting element LD may further include an insulation film 40 provided on a surface thereof. The insulation film 40 may be formed on the surface of the light emitting element LD so as to surround an outer circumferential surface of the active layer 20, and may further surround areas of the first and second semiconductor layers 10 and 30. However, in some embodiments, the insulation film 40 may expose end portions of the light emitting element LD having different polarities. For example, the insulation film 40 may not cover but expose respective end portions of the first semiconductor layer 10 and the second semiconductor layer 30 disposed at end portions of the light emitting element LD in the length L direction, for example, two bottom surfaces of a cylindrical shape (upper and lower surfaces of the light emitting element LD).

In case that the insulation film 40 is provided on a surface of the light emitting element LD, particularly, a surface of the active layer 20, it is possible to prevent the active layer 20 from being short-circuited with at least one electrode not shown (for example, at least one of the contact electrodes electrically connected to end portions of the light emitting element LD). Therefore, electrical stability of the light emitting element LD may be secured.

In the embodiment, the light emitting element LD may further include an additional component in addition to the first semiconductor layer 10, the active layer 20, the second semiconductor layer 30, and the insulation film 40. For example, the light emitting element LD may additionally include at least one phosphor layer, at least one active layer, at least one semiconductor layer, and/or at least one electrode disposed on sides of the first semiconductor layer 10, the active layer 20, and the second semiconductor layer 30.

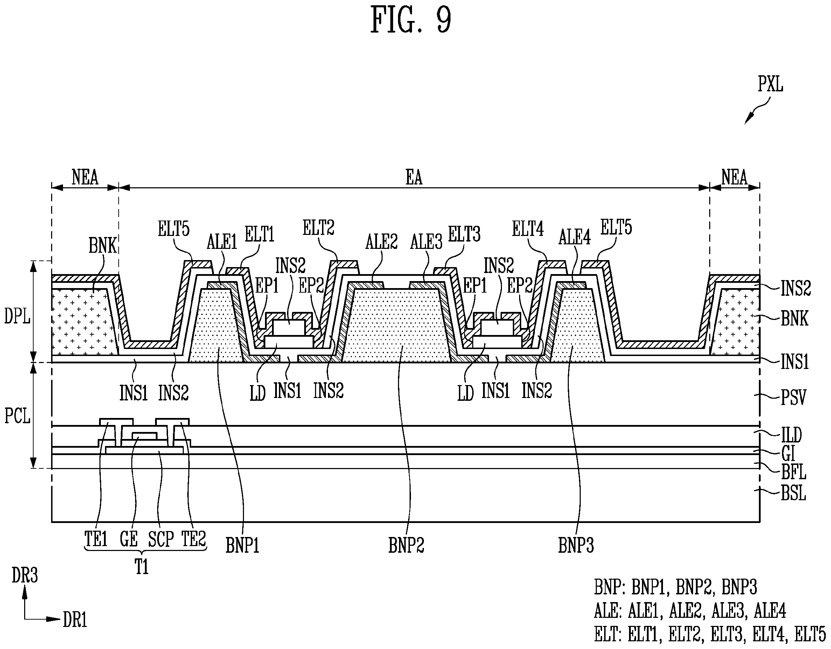

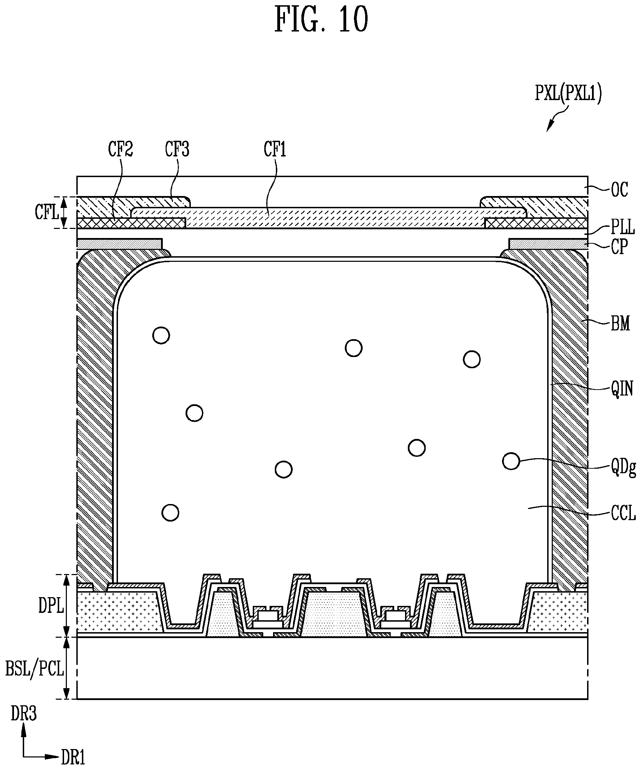

Hereinafter, a structure of a pixel according to an embodiment will be described with reference to FIGS. 9 and 10.

FIG. 9 illustrates an example of a pixel included in a display device according to an embodiment, and FIG. 10 illustrates an example of a pixel according to an embodiment.

Referring to FIG. 9, a pixel PXL according to an embodiment may include a base layer BSL, and a pixel circuit layer PCL and a display element layer DPL that are disposed on a surface of the base layer BSL.

The base layer BSL may be a rigid substrate or a flexible substrate, and may include a transparent insulation material to transmit light. The base layer BSL may include a light emitting area EA in which the light emitting element LD is disposed to emit light and a non-light emitting area NEA that does not emit light.

The pixel circuit layer PCL may include a buffer layer BFL, a first transistor T1, insulation layers GI and ILD, and a passivation layer PSV.

The buffer layer BFL may prevent impurities from spreading into the pixel circuit layer PCL. The buffer layer BFL may be an inorganic insulation film including an inorganic material. For example, the buffer layer BFL may include at least one of metal oxides such as a silicon nitride (SiNₓ), a silicon oxide (SiOₓ), a silicon oxynitride (SiOₓN_{y}), and an aluminum oxide (AlOₓ). The buffer layer BFL may be omitted depending on the material, a process condition, and the like of the base layer BSL.

The first transistor T1 may include a semiconductor pattern SCP, a gate electrode GE, a drain electrode TE1, and a source electrode TE2. In some embodiments, the drain electrode TE1 and the source electrode TE2 may be interchanged with each other.

The semiconductor pattern SCP is positioned on the buffer layer BFL. The semiconductor pattern SCP may include a drain region electrically connected to the drain electrode TE1, a source region electrically connected to the source electrode TE2, and a channel region between the drain region and the source region. The channel region may overlap the gate electrode GE of the first transistor T1. The semiconductor pattern SCP may be formed of a polysilicon, an amorphous silicon, an oxide semiconductor, or the like.

The gate insulation layer GI is disposed on the semiconductor pattern SCP to cover the semiconductor pattern SCP and the buffer layer BFL. The gate insulation layer GI may be an inorganic insulation film including an inorganic material. For example, the gate insulation layer GI may include at least one of metal oxides such as a silicon nitride (SiNₓ), a silicon oxide (SiOₓ), a silicon oxynitride (SiOₓN_{y}), and an aluminum oxide (AlOₓ). In some embodiments, the gate insulation layer GI may be formed as an organic insulation film including an organic material. The gate insulation layer GI may be provided as a single film, or may be provided as a multifilm of two or more films.

The gate electrode GE is disposed on the gate insulation layer GI so as to overlap the channel region of the semiconductor pattern SCP. The gate electrode GE may be configured of a single film made of at least one material selected from a group including copper (Cu), molybdenum (Mo), tungsten (W), aluminum neodymium (AlNd), titanium (Ti), aluminum (Al), silver (Ag), and an alloy thereof or mixture or combination thereof. In addition, the gate electrode GE may be configured of a double film or multifilm structure of at least one low-resistance material such as molybdenum (Mo), titanium (Ti), copper (Cu), aluminum (Al), or silver (Ag).

The interlayer insulation layer ILD is positioned on the gate electrode GE to cover the gate electrode GE and the gate insulation layer GI. The interlayer insulation layer ILD and the gate insulation layer GI may include a same material, or the interlayer insulation layer ILD may include at least one selected from the materials that may be used to form the gate insulation layer GI, e.g., as described herein.

The interlayer insulation layer ILD may include a contact hole for electrically connecting the drain electrode TE1 of the first transistor T1 and the source electrode TE2 of the first transistor T1 to the drain region and the source region of the semiconductor pattern SCP, respectively.

The drain electrode TE1 of the first transistor T1 and the source electrode TE2 of the first transistor T1 are positioned on the interlayer insulation layer ILD.

The drain electrode TE1 and the source electrode TE2 may be electrically connected to the source region and the drain region of the semiconductor pattern SCP through contact holes sequentially penetrating the gate insulation layer GI and the interlayer insulation layer ILD, respectively. The drain electrode TE1 and the first terminal of the first transistor T1 described with reference to FIG. 7 may have a same configuration, and the source electrode TE2 and the second terminal of the first transistor T1 described with reference to FIG. 7 may have a same configuration.

The passivation layer PSV is positioned on the drain electrode TE1 and the source electrode TE2 of the first transistor T1 to cover (or overlap, e.g., in a plan view) the drain electrode TE1 and the source electrode TE2 of the first transistor T1, and the interlayer insulation layer ILD.

The passivation layer PSV may include an inorganic insulation film and/or an organic insulation film. The inorganic insulation film may include at least one of metal oxides such as a silicon oxide (SiOₓ), a silicon nitride (SiNₓ), a silicon oxynitride (SiOₓN_{y}), and an aluminum oxide (AlOₓ). The organic insulation film may be at least one of a polyacrylates resin, an epoxy resin, a phenolic resin, a polyamides resin, a polyimides rein, an unsaturated polyesters resin, a polyphenylene ethers resin, a polyphenylene sulfides resin, and a benzocyclobutene resin.

The passivation layer PSV may include a contact hole exposing the source electrode TE2 of the first transistor T1, and the source electrode TE2 of the first transistor T1 may be physically and/or electrically connected to the first pixel electrode ELT1 through the contact hole of the passivation layer PSV.

The display element layer DPL may be positioned on the passivation layer PSV.

The display element layer DPL may include a bank pattern BNP, a bank BNK, an alignment electrode ALE, a light emitting element LD, a pixel electrode ELT, and insulation layers INS1 and INS2.

The bank pattern BNP is positioned on the passivation layer PSV. The bank pattern BNP may have a cross-section of a trapezoidal shape, a width of which reduces from a surface (for example, an upper surface) facing the passivation layer PSV toward an upper portion thereof in the third direction DR3. In some embodiments, the bank pattern BNP may include a curved surface having a cross section of a semi-elliptic shape or a semi-circular shape (or semi-spherical shape), a width of which reduces upward from a surface facing the passivation layer PSV in the third direction DR3. In a cross-sectional view, the shape of the bank pattern BNP is not limited to the above-described embodiments, and the shape thereof may be variously changed insomuch as the bank pattern BNP may improve efficiency of light emitted from each of the light emitting elements LD.

The bank pattern BNP may be an inorganic insulation film including an inorganic material or an organic insulation film including an organic material. In some embodiments, the bank pattern BNP may include an organic insulation film of a single film and/or an inorganic insulation film of a single layer, but the disclosure is not limited thereto. In some embodiments, the bank pattern BNP may be omitted.

The bank pattern BNP may include a first bank pattern BNP1, a second bank pattern BNP2, and a third bank pattern BNP3 that are positioned to be spaced apart from each other in a first direction DR1. At least one light emitting element LD may be disposed between two of the first bank pattern BNP1, the second bank pattern BNP2, and the third bank pattern BNP3.

The alignment electrode ALE may be positioned on the bank pattern BNP. When viewed in a cross-sectional view, each alignment electrode ALE may have a surface profile corresponding to a shape of the bank pattern BNP. In some embodiments, in case that the bank pattern BNP is omitted, the alignment electrode ALE may be positioned on an upper surface of the passivation layer PSV.

Each alignment electrode ALE may be made of a material having a reflectance (e.g., a predetermined or selected reflectance) in order to direct light emitted from the light emitting element LD in an image display direction of the display device (for example, the third direction DR3). For example, each alignment electrode ALE may be configured as a single film including a conductive oxide such as an indium tin oxide (ITO), an indium zinc oxide (IZO), a zinc oxide (ZnO), an indium gallium zinc oxide (IGZO), or an indium tin zinc oxide (ITZO), and a conductive polymer such as poly(3,4-ethylenedioxythiophene (PEDOT). In addition, each alignment electrode ALE may be configured as a multi-film further including at least one of various metals such as silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), copper (Cu), and the like, or an alloy thereof.

The alignment electrode ALE may include a first alignment electrode ALE1, a second alignment electrode ALE2, a third alignment electrode ALE3, and a fourth alignment electrode ALE4 that are positioned to be spaced apart from each other in the first direction DR1.

The first alignment electrode ALE1 may be positioned on the first bank pattern BNP1 and the passivation layer PSV, the second alignment electrode ALE2 may be positioned on the second bank pattern BNP2 and the passivation layer PSV, the third arrangement electrode ALE3 may be positioned on the second bank pattern BNP2 and the passivation layer PSV, and the fourth alignment electrode ALE4 may be positioned on the third bank pattern BNP3 and the passivation layer PSV.

Each of the first alignment electrode ALE1 or the third alignment electrode ALE3 may be physically and/or electrically connected to the source electrode TE2 of the first transistor T1 through a contact hole (not shown) of the passivation layer PSV.

The first insulation layer INS1 is positioned on the alignment electrode ALE, the bank pattern BNP, and the passivation layer PSV to cover the alignment electrode ALE, the bank pattern BNP, and the passivation layer PSV. The first insulation layer INS1 may be positioned between two adjacent alignment electrodes among the first alignment electrode ALE1, the second alignment electrode ALE2, the third alignment electrode ALE3, and the fourth alignment electrode ALE4 so that the two alignment electrodes may not be short-circuited with each other.

The first insulation layer INS1 may include an inorganic insulation film made of an inorganic material or an organic insulation film made of an organic material. For example, the first insulation layer INS1 may include at least one of metal oxides such as a silicon nitride (SiNₓ), a silicon oxide (SiOₓ), a silicon oxynitride (SiOₓN_{y}), and an aluminum oxide (AlOₓ), but the disclosure is not limited thereto. The first insulation layer INS1 may be formed as an inorganic insulation film or an organic insulation film that is advantageous in protecting the light emitting elements LD from the pixel circuit layer PCL.

The light emitting element LD is positioned on the first insulation layer INS1. A first end portion EP1 of a light emitting element LD may be positioned to face the first alignment electrode ALE1, and a second end portion EP2 of the light emitting element LD may be positioned to face the second alignment electrode ALE2. In addition, a first end portion EP1 of another light emitting element LD may be positioned to face the third alignment electrode ALE3, and a second end portion EP2 of the another light emitting element LD may be positioned to face the fourth alignment electrode ALE4. Accordingly, the light emitting element LD may receive a voltage of the first driving power source VDD (see FIG. 7) through the first end portion EP1, and may receive a voltage of the second driving power source VSS (see FIG. 7) through the second end portion EP2.

The bank BNK may be disposed on the first insulation layer INS1. The bank BNK may be positioned in the non-light emitting area NEA. In a process of supplying the light emitting elements LD to the light emitting area EA, the bank BNK may be a dam structure that prevents a solution including the light emitting elements LD from flowing into the light emitting area EA of the adjacent pixel PXL, or controls an amount (e.g., a predetermined or selected amount) of solution to be supplied to each light emitting area EA.

The bank BNK may be configured to include a light blocking material and/or a reflective material to prevent a light leakage defect in which light leaks between each pixel PXL and pixels PXL adjacent thereto. In some embodiments, the bank BNK may include a transparent material. As an example, it may include a polyamides resin, a polyimide resin, and the like, but the disclosure is not limited thereto. According to an embodiment, a reflective layer (or reflective material layer) may be separately provided and/or formed on the bank BNK to further improve an efficiency of light emitted from the pixel PXL.

In the embodiment, although it has been described that the bank BNK is positioned on the first insulation layer INS1, the disclosure is not limited thereto. In some embodiments, the bank BNK may be positioned on an upper surface of the passivation layer PSV, and may be positioned to at least partially overlap the alignment electrode ALE.

The second insulation layer INS2 may be positioned on the light emitting element LD. The second insulation layer INS2 may be positioned on a portion of the upper surface of the light emitting element LD so that the first end portion EP1 and the second end portion EP2 of the light emitting element LD may be exposed to the outside. After the alignment of the light emitting elements LD is completed in the pixel PXL, by positioning the second insulation layer INS2 on the light emitting elements LD, it is possible to prevent the light emitting elements LD from deviating from the aligned position.

In addition, the second insulation layer INS2 may be positioned to overlap a portion of the first insulation layer INS1. The second insulation layer INS2 may be entirely positioned on the light emitting area EA and the non-light emitting area NEA.

The second insulation layer INS2 may be formed as a single film or multi-film, and may include an inorganic insulation film including at least one inorganic material or an organic insulation film including at least one organic material. For example, the second insulation layer INS2 may include at least one of metal oxides such as a silicon nitride (SiNₓ), a silicon oxide (SiOₓ), a silicon oxynitride (SiOₓN_{y}), and an aluminum oxide (AlOₓ), but the disclosure is not limited thereto.

In case that there is a gap (or space) between the first insulation layer INS1 and the light emitting element LD before the second insulation layer INS2 is formed, the gap may be filled with the second insulation layer INS2 in the process of forming the second insulation layer INS2. In this case, the second insulation layer INS2 may be formed as an insulation film that is advantageous in filling the gap between the first insulation layer INS1 and the light emitting element LD. For example, depending on a design condition of the display device including the light emitting elements LD, the second insulation layer INS2 may be formed of an organic insulation film including an organic material.

The pixel electrode ELT is positioned to overlap at least some of the alignment electrode ALE, the first insulation layer INS1, the light emitting element LD, and the second insulation layer INS2.

The pixel electrode ELT may include a transparent conductive material such as an indium tin oxide (ITO), an indium zinc oxide (IZO), a zinc oxide (ZnO), and an indium gallium zinc oxide (IGZO).

The pixel electrode ELT may include a first pixel electrode ELT1, a second pixel electrode ELT2, a third pixel electrode ELT3, a fourth pixel electrode ELT4, and a fifth pixel electrode ELT5.

The first pixel electrode ELT1 may directly contact the first end portion EP1 of the light emitting element LD, and may be physically and/or electrically connected to the first end portion EP1 of the light emitting element LD. The first pixel electrode ELT1 may directly contact the first alignment electrode ALE1 exposed by the first insulation layer INS1 to be physically and/or electrically connected thereto.

The second pixel electrode ELT2 may directly contact the second end portion EP2 of the light emitting element LD, and may be physically and/or electrically connected to the second end portion EP2 of the light emitting element LD. The second pixel electrode ELT2 may directly contact the second alignment electrode ALE2 exposed by the first insulation layer INS1 to be physically and/or electrically connected thereto.

The third pixel electrode ELT3 may directly contact the first end portion EP1 of the light emitting element LD, and may be physically and/or electrically connected to the first end portion EP1 of the light emitting element LD. The third pixel electrode ELT3 may directly contact the third alignment electrode ALE3 exposed by the first insulation layer INS1 to be physically and/or electrically connected thereto.

The fourth pixel electrode ELT4 may directly contact the second end portion EP2 of the light emitting element LD, and may be physically and/or electrically connected to the second end portion EP2 of the light emitting element LD. The fourth pixel electrode ELT4 may directly contact the fourth alignment electrode ALE4 exposed by the first insulation layer INS1 to be physically and/or electrically connected thereto.

The fifth pixel electrode ELT5 may be positioned on the second insulation layer INS2, and may be positioned to be spaced apart from the first pixel electrode ELT1 and the fourth pixel electrode ELT4. The fifth pixel electrode ELT5 may be entirely positioned on the bank pattern BNP and the bank BNK in the light emitting area EA and the non-light emitting area NEA.

Referring to FIG. 10, the pixel PXL (or first pixel PXL1) according to an embodiment may include a color conversion layer CCL, a black matrix pattern BM, a color filter layer CFL, and an overcoat layer OC that are positioned on the display element layer DPL.

The color conversion layer CCL may include at least one type of color conversion particle corresponding to a color of light emitted from each pixel PXL. In the embodiment, in case that the light emitting elements LD disposed in the first pixel PXL1 emit blue light and the first pixel PXL1 is a green pixel, the color conversion layer CCL may include a green quantum dot QDg that converts the blue light emitted from the light emitting elements LD into green light. For example, the color conversion layer CCL may include green quantum dots QDg dispersed in a matrix material such as a transparent resin. However, the disclosure is not limited thereto, and in case that the light emitting elements LD disposed in the second pixel PXL2 emit blue light and the second pixel PXL2 is a red pixel, the color conversion layer CCL may include a red quantum dot that converts the blue light emitted from the light emitting elements LD into red light. In addition, in case that the light emitting elements LD disposed in the third pixel PXL3 emit blue light and the third pixel PXL3 is a blue pixel, the color conversion layer CCL may include at least one type of light scattering particles.

A light insulation layer QIN may be disposed on a surface of the color conversion layer CCL. The light insulation layer QIN may be disposed to surround the color conversion layer CCL, and may at least partially overlap the display element layer DPL.

The light insulation layer QIN may be an inorganic insulation film. For example, the light insulation layer QIN may include at least one of metal oxides such as a silicon nitride (SiNₓ), a silicon oxide (SiOₓ), a silicon oxynitride (SiOₓN_{y}), and an aluminum oxide (AlOₓ).

The black matrix pattern BM may be positioned at both sides of the color conversion layer CCL. Specifically, the black matrix pattern BM may be positioned to directly contact a side surface of the light insulation layer QIN.

The black matrix pattern BM may include at least one black matrix material (for example, at least one light blocking material) among various types of black matrix materials, and/or a color filter material of a specific color.

The conductive pattern CP is positioned on the black matrix pattern BM. The conductive pattern CP may be positioned to at least partially overlap the black matrix pattern BM.

The conductive pattern CP may include a transparent electrode material. For example, the conductive pattern CP may include a transparent conductive oxide such as an indium tin oxide (ITO), an indium zinc oxide (IZO), a zinc oxide (ZnO), an indium gallium zinc oxide (IGZO), and an indium tin zinc oxide (ITZO), but the disclosure is not limited thereto.

The conductive pattern CP may include a conductive polymer material. For example, the conductive pattern CP may include a conductive polymer such as polyacetylene, polypyrrole, polythiophene, poly(3,4-ethylenedioxythiophene) (PEDOT), or polyaniline, but the disclosure is not limited thereto.

A planarization layer PLL may be positioned on the color conversion layer CCL, the light insulation layer QIN, and the conductive pattern CP. The planarization layer PLL may be configured as a single layer or multilayer including at least one layer of organic film. For example, the planarization layer PLL may include a low refractive organic film, thereby securing light efficiency of the pixel PXL.

The color filter layer CFL may be positioned on the planarization layer PLL.

The color filter layer CFL may include a first color filter CF1, a second color filter CF2, and a third color filter CF3 that match colors of respective pixels PXL.

In the embodiment, in case that the first pixel PXL1 is a green pixel, the first color filter CF1 may be a green color filter. In addition, in case that a pixel adjacent to the first pixel PXL1 is a red pixel, the second color filter CFL2 may be a red color filter, and in case that another pixel adjacent to the first pixel PXL1 is a blue pixel, the third color filter CF3 may be a blue color filter.

The color filters CF1, CF2, and CF3 positioned at a portion overlapping the black matrix pattern BM in the color filter layer CFL may overlap each other and thus may have a light blocking function similar to that of the black matrix pattern BM.

The overcoat layer OC may be positioned on the color filter layer CFL to cover the color filter layer CFL.

The overcoat layer OC may be a planarization film for alleviating a step in a structure thereunder, and may include an organic material such as a polyimide, a benzocyclobutene series resin, and an acrylate.

Hereinafter, various shapes of a conductive pattern according to an embodiment will be described with reference to FIGS. 11 to 13.

FIGS. 11 to 13 illustrate a display panel according to an embodiment. The display panel of FIGS. 11 to 13 is similar to the display panel described with reference to FIG. 2, and thus differences therebetween will now be mainly described.

Referring to FIGS. 11 to 13, the display panel 100 according to the embodiment may include a base layer BSL, and pixels PXL, a black matrix pattern BM, and a conductive pattern CP that are disposed on the base layer BSL.

The black matrix pattern BM may be partially positioned in the display area DA and the non-display area NDA. In the display area DA, the black matrix pattern BM may be positioned between the pixels PXL. In the non-display area NDA, the black matrix pattern BM may be positioned to surround the display area DA.

In the embodiment, the pixels PXL may be disposed in a matrix format. Accordingly, in the display area DA, the black matrix pattern BM may have a mesh shape surrounding all of the pixels PXL.

The conductive pattern CP may at least partially overlap the black matrix pattern BM. The black matrix pattern BM may be positioned under the conductive pattern CP.

In the embodiment, the conductive pattern CP may be positioned to surround two or more pixels PXL disposed in the first direction DR1 (or a row direction) and the second direction DR2 (or a column direction).

For example, referring to FIG. 11, the conductive pattern CP may be positioned to surround two pixels PXL in the row direction and two pixels PXL in the column direction, for example, four pixels PXL.

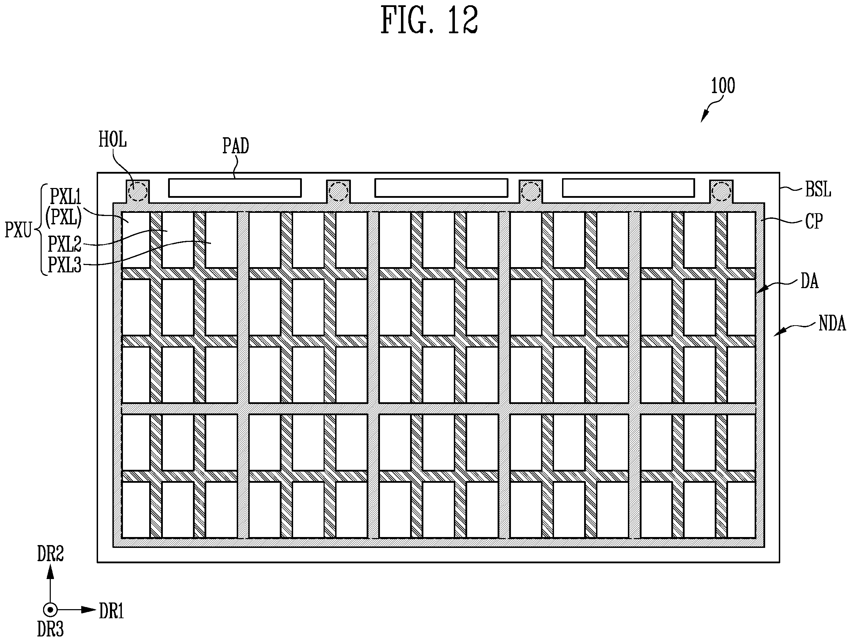

In addition, referring to FIG. 12, the conductive pattern CP may be positioned to surround three pixels PXL in the row direction and three pixels PXL in the column direction, for example, nine pixels PXL. However, the disclosure is not limited thereto. In some embodiments, the conductive pattern CP may be positioned to surround six pixels PXL, and the number of pixels PXL surrounded by the conductive pattern CP may be variously changed.

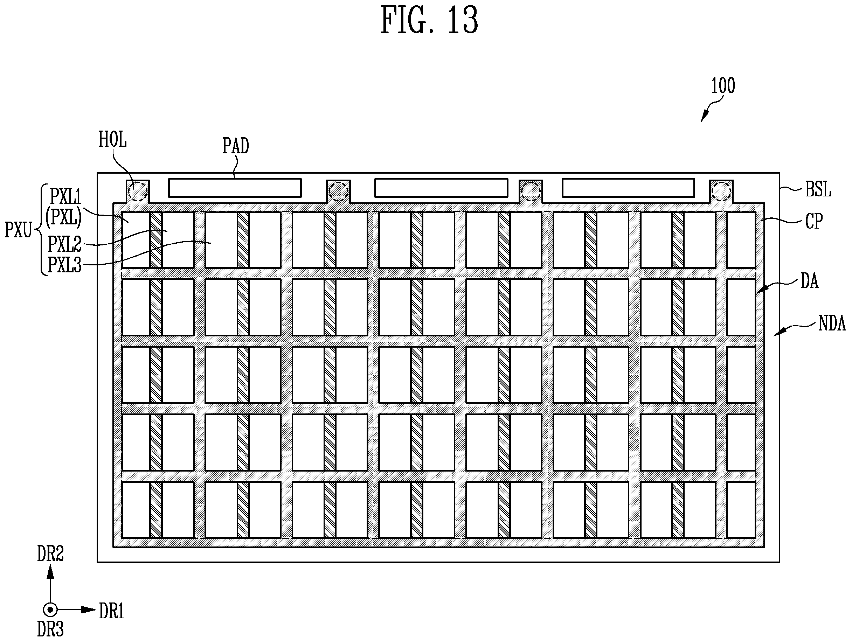

Referring to FIG. 13, the conductive pattern CP may be positioned to surround two pixels PXL in the row direction and a pixel PXL in the column direction, for example, two pixels PXL. However, the disclosure is not limited thereto, and the conductive pattern CP may be positioned to surround a different number of pixels PXL in the row direction and the column direction. For example, the conductive pattern CP may be positioned to surround three pixels PXL in the row direction and four pixels PXL in the column direction, and may also be positioned to surround six pixels PXL in the row direction and a pixel in the column direction PXL.

The conductive pattern CP may be positioned to overlap at least one hole HOL, and may be electrically connected to the housing 200 through the at least one hole HOL.

The display device according to the embodiment may have the conductive pattern CP that is disposed in the display area DA and the non-display area NDA of the display panel 100 and is electrically connected to the housing 200 through at least one hole HOL of the non-display area NDA, to induce, toward the outside, static electricity that may occur from the upper portion of the display panel 100, thereby preventing static electricity on the display panel 100. Accordingly, the display device according to the embodiment may improve the quality of the display panel 100.

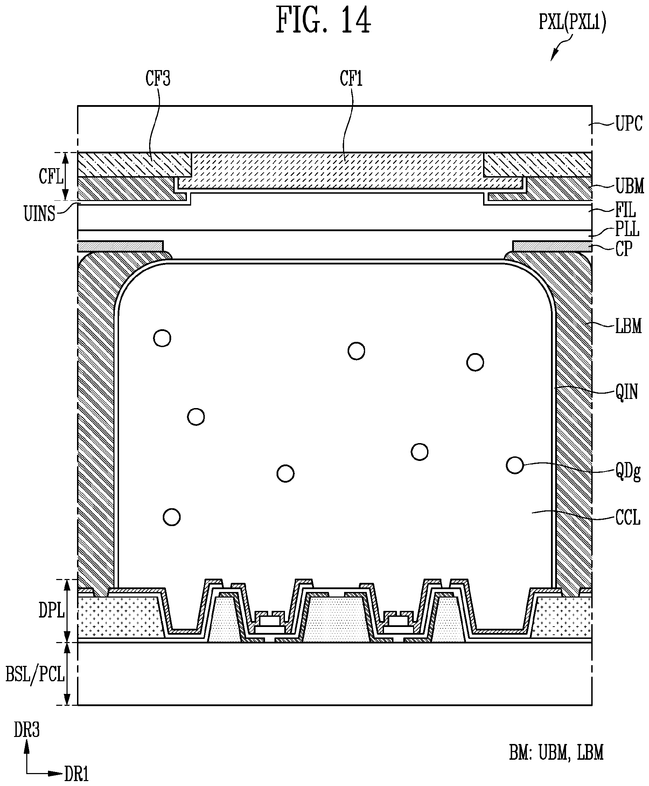

Hereinafter, a structure of a pixel according to an embodiment will be described with reference to FIGS. 14 to 16.

FIGS. 14 to 16 illustrate examples of a pixel according to an embodiment.

A base layer BSL, a pixel circuit layer PCL, a display element layer DPL, a color conversion layer CCL, a conductive pattern CP, and a planarization layer PLL shown in FIG. 14 are the same as the base layer BSL, the pixel circuit layer PCL, the display element layer DPL, the color conversion layer CCL, the conductive pattern CP, and the planarization layer PLL described with reference to FIGS. 9 and 10, and thus differences therebetween will now be mainly described.

Referring to FIG. 14, the black matrix pattern BM may include a lower black matrix pattern LBM and an upper black matrix pattern UBM.

The lower black matrix pattern LBM may be positioned on the display element layer DPL, and may be positioned on both sides of the color conversion layer CCL.

The upper black matrix pattern UBM may overlap the lower black matrix pattern LBM. In the first direction DR1, a width of the upper black matrix pattern UBM may be larger than that of the lower black matrix pattern LBM.

A filler FIL may be positioned on the planarization layer PLL. The filler FIL may prevent damage to the display device due to impact and the like, and may secure stability of the display device. The filler FIL may be made of a material having both elasticity and adhesiveness.

An upper insulation layer UINS may be positioned between the filler FIL and the color filter layer CFL. The upper insulation layer UINS may be positioned to contact a surface of the color filter layer CFL.

The upper insulation layer UINS may be an inorganic insulation film including an inorganic material. For example, the upper insulation layer UINS may include at least one of metal oxides such as a silicon nitride (SiNₓ), a silicon oxide (SiOₓ), a silicon oxynitride (SiOₓN_{y}), and an aluminum oxide (AlOₓ).

An upper substrate UPC may be positioned on the color filter layer CFL.

The upper substrate UPC may be a rigid or flexible substrate (or film). In the embodiment, in case that the upper substrate UPC is a rigid substrate, the upper substrate UPC may be one of a glass substrate, a quartz substrate, a glass ceramic substrate, and a crystalline glass substrate. In an embodiment, in case that the upper substrate UPC is a flexible substrate, the upper substrate UPC may be one of a film substrate including a polymer organic material and a plastic substrate. In addition, the upper substrate UPC may include fiberglass reinforced plastic (FRP).

The upper substrate UPC, which is disposed on a surface of the base layer BSL on which the pixels PXL are disposed, may be referred to as an encapsulation substrate or a color filter substrate.

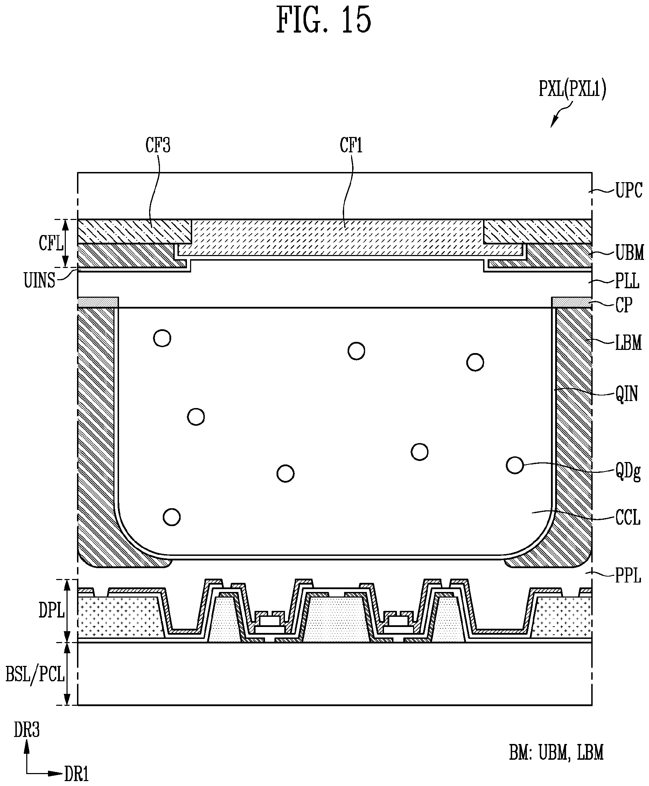

A base layer BSL, a pixel circuit layer PCL, and a display element layer DPL shown in FIG. 15 are the same as the base layer BSL, the pixel circuit layer PCL, and the display element layer DPL described with reference to FIGS. 9 and 10, and thus differences therebetween will now be mainly described.

Referring to FIG. 15, a planar organic layer PPL may be positioned on the display element layer DPL.

The color conversion layer CCL surrounded by the light insulation layer QIN may be positioned on the planar organic layer PPL. The light insulation layer QIN shown in FIG. 15 may be disposed in an opposite direction in a vertical direction to the light insulation layer QIN described with reference to FIG. 10.

The black matrix pattern BM may include the lower black matrix pattern LBM and the upper black matrix pattern UBM.

The lower black matrix pattern LBM may be positioned on the planar organic layer PPL, and may be positioned at both sides of the color conversion layer CCL.

The conductive pattern CP may be positioned on the lower black matrix pattern LBM.

The planarization layer PLL may be positioned on the color conversion layer CCL, the light insulation layer QIN, and the conductive pattern CP.

The upper black matrix pattern UBM may be positioned on the planarization layer PLL. The upper black matrix pattern UBM may overlap the lower black matrix pattern LBM. In the first direction DR1, a width of the upper black matrix pattern UBM may be larger than that of the lower black matrix pattern LBM.

The color filter layer CFL may be positioned on the planarization layer PLL.

The color filter layer CFL may include a first color filter CF1, a second color filter CF2, and a third color filter CF3 that match colors of respective pixels PXL.

An upper insulation layer UINS may be positioned between the filler FIL and the color filter layer CFL. The upper insulation layer UINS may be positioned to contact a surface of the color filter layer CFL.

The upper substrate UPC may be positioned on the color filter layer CFL.

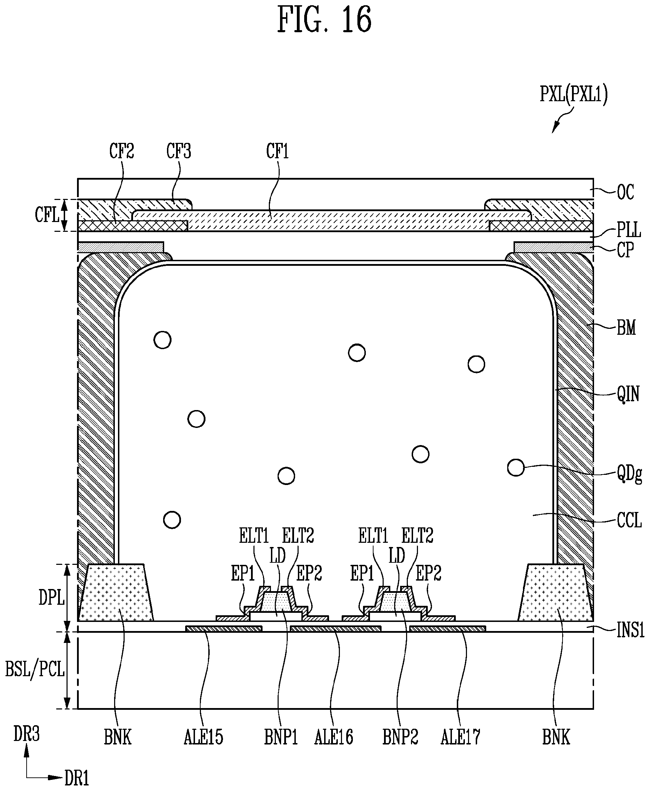

The pixel PXL shown in FIG. 16 is similar to the pixel PXL described with reference to FIGS. 9 and 10, and thus the display element layer DPL having a difference will now be mainly described.

Referring to FIG. 16, the display element layer DPL may include alignment electrodes ALE15, ALE16, and ALE17, a first insulation layer INS1, a light emitting element LD, bank patterns BNP1 and BNP2, a bank BNK, a first pixel electrode ELT1, and a second pixel electrode ELT2.

The alignment electrodes ALE15, ALE16, and ALE17 may be positioned on the pixel circuit layer PCL. The alignment electrodes ALE15, ALE16, and ALE17 may include a fifteenth alignment electrode ALE15, a sixteenth alignment electrode ALE17, and a seventeenth alignment electrode ALE17 that are positioned to be spaced apart from each other in the first direction DR1.

The first insulation layer INS1 may be positioned on the alignment electrodes ALE15, ALE16, and ALE17 and the pixel circuit layer PCL to cover the alignment electrodes ALE15, ALE16, and ALE17.

The light emitting element LD is positioned on the first insulation layer INS1. A first end portion EP1 of a light emitting element LD may be positioned to face the fifteenth alignment electrode ALE15, and a second end portion EP2 of the light emitting element LD may be positioned to face the sixteenth alignment electrode ALE16. In addition, a first end portion EP1 of another light emitting element LD may be positioned to face the sixteenth alignment electrode ALE16, and a second end portion EP2 of another light emitting element LD may be positioned to face the seventeenth alignment electrode ALE17. Accordingly, in case that an alignment voltage is applied to the alignment electrodes ALE15, ALE16, and ALE17, the light emitting element LD may be aligned in a direction.

The bank BNK may be disposed on the first insulation layer INS1.

The bank patterns BNP1 and BNP2 may be positioned on the light emitting element LD. The bank patterns BNP1 and BNP2 may be positioned on a portion of the upper surface of the light emitting element LD so that the first end portion EP1 and the second end portion EP2 of the light emitting element LD may be exposed to the outside. After the alignment of the light emitting elements LD is completed in the pixel PXL, the bank patterns BNP1 and BNP2 may be positioned on the light emitting elements LD, and thus the light emitting elements LD may be prevented from deviating from the aligned position.

The bank pattern BNP may include a first bank pattern BNP1 and a second bank pattern BNP2.

The first pixel electrode ELT1 may be positioned to overlap at least portions of the first bank pattern BNP1 and the second bank pattern BNP2, and the first end portion EP1 of the light emitting element LD. The first pixel electrode ELT1 may directly contact the first end portion EP1 of the light emitting element LD to be physically and/or electrically connected to the first end portion EP1 of the light emitting element LD.

The second pixel electrode ELT2 may be positioned to overlap at least a portion of the first bank pattern BNP1 and the second bank pattern BNP2, and the second end portion EP2 of the light emitting element LD.

The second pixel electrode ELT2 may directly contact the second end portion EP2 of the light emitting element LD to be physically and/or electrically connected to the second end portion EP2 of the light emitting element LD.

The color conversion layer CCL and the black matrix pattern BM may be positioned on the display element layer DPL. The conductive pattern CP may be positioned on the black matrix pattern BM.

The display device according to the embodiment may have the conductive pattern CP that is disposed on the display panel and is electrically connected to the housing through at least one hole of the non-display area, to induce, toward the outside, static electricity that may occur from the upper portion of the display panel, thereby preventing static electricity on the display panel. Accordingly, the display device according to the embodiment may improve the quality of the display panel.

The above description is an example of technical features of the invention, and those skilled in the art to which the disclosure pertains will be able to make various modifications and variations while still falling within the scope of the invention as defined by the claims. The embodiments of the disclosure described above may be implemented separately or in combination with each other.

## Claims

1. A display device (1000) comprising:
a rollable display panel (100) that includes:
a display area (DA) arranged to display an image; a non-display area (NDA); and
a base layer (BSL) including at least one hole (HOL) defined in the non-display area (NDA); and
a housing (200) connected to the rollable display panel (100) and configured to accommodate the rollable display panel (100),
wherein the rollable display panel (100) includes:
pixels (PXL) disposed on the display area (DA) of the base layer (BSL); and
a conductive pattern (CP) disposed on the base layer (BSL) between the pixels (PXL) in the display area (DA) and overlapping the at least one hole (HOL) in a plan view, and
wherein the conductive pattern (CP) is electrically connected to the housing (200) through the at least one hole (HOL).

2. The display device of claim 1, wherein the conductive pattern includes a transparent electrode material.

3. The display device of claim 1, wherein the conductive pattern includes a conductive polymer material.

4. The display device of claim 1, 2 or 3, further comprising:
a black matrix pattern disposed between the pixels in the display area,
wherein the conductive pattern overlaps the black matrix pattern in a plan view.

5. The display device of any one of the preceding claims, wherein
the housing includes a housing groove (220) accommodating the rollable display panel.

6. The display device of any one of the preceding claims, wherein the rollable display panel further includes:
a first pad electrode (PE1) overlapping the at least one hole in the non-display area in a plan view;
a second pad electrode (PE2) disposed on the first pad electrode and electrically contacting the first pad electrode; and
a third pad electrode (PE3) disposed on the second pad electrode and electrically contacting the second pad electrode, and
the conductive pattern electrically contacting the third pad electrode.

7. The display device of claim 6, further comprising:
a connection member (250) disposed on a surface of the first pad electrode in the at least one hole and electrically connecting the conductive pattern and the housing.

8. The display device of claim 7, wherein the connection member is a paste including a conductive material.

9. The display device of any one of the preceding claims, wherein
the pixels are disposed to be spaced apart from each other in a matrix format, and
the conductive pattern has a mesh shape surrounding each of the pixels.

10. The display device of any one of claims 1 to 8, wherein
the pixels are disposed to be spaced apart from each other in a matrix format, and
the conductive pattern surrounds two or more of the pixels.

11. The display device of any one of the preceding claims, wherein
pad parts are disposed in the non-display area, and
the at least one hole is respectively formed between the pad parts.

12. The display device of claim 4 or any one of claims 5 to 11 when dependent on claim **4,** wherein the display device further comprises:
a color conversion layer (CCL) disposed on the base layer in the display area and including at least one type of color conversion particle;
wherein the black matrix pattern is disposed at both sides of the color conversion layer.

13. The display device of claim 12, further comprising:
a planarization layer (PLL) covering the color conversion layer and the conductive pattern; and
a color filter layer (CFL) disposed on the planarization layer and including a color filter (CF1, CF2, CF3) corresponding to a color of the color conversion particle.

14. The display device of claim 13, further comprising:
an upper substrate (UPC) disposed on the color filter layer.

## Patentansprüche

1. Anzeigevorrichtung (1000), umfassend:
ein aufrollbares Anzeigefeld (100), das beinhaltet:
einen Anzeigebereich (DA), der dazu angeordnet ist, ein Bild anzuzeigen; einen Nicht-Anzeigebereich (NDA); und
eine Basisschicht (BSL), die mindestens ein Loch (HOL) beinhaltet, das in dem Nicht-Anzeigebereich (NDA) definiert ist; und
ein Gehäuse (200), das mit dem aufrollbaren Anzeigefeld (100) verbunden ist und dazu konfiguriert ist, das aufrollbare Anzeigefeld (100) aufzunehmen,
wobei das aufrollbare Anzeigefeld (100) beinhaltet:
Pixel (PXL), die auf dem Anzeigebereich (DA) der Basisschicht (BSL) angeordnet sind; und
ein Leiterbild (CP), das auf der Basisschicht (BSL) zwischen den Pixeln (PXL) in dem Anzeigebereich (DA) angeordnet ist und das mindestens eine Loch (HOL) in einer Draufsicht überlappt, und
wobei das Leiterbild (CP) elektrisch mit dem Gehäuse (200) durch das mindestens eine Loch (HOL) verbunden ist.

2. Anzeigevorrichtung nach Anspruch 1, wobei das Leiterbild ein transparentes Elektrodenmaterial beinhaltet.

3. Anzeigevorrichtung nach Anspruch 1, wobei das Leiterbild ein leitendes Polymermaterial beinhaltet.

4. Anzeigevorrichtung nach Anspruch 1, 2 oder 3, ferner umfassend:
ein Schwarzmatrixmuster, das zwischen den Pixeln in dem Anzeigebereich angeordnet ist, wobei das Leiterbild das Schwarzmatrixmuster in einer Draufsicht überlappt.

5. Anzeigevorrichtung nach einem der vorhergehenden Ansprüche, wobei
das Gehäuse eine Gehäusenut (220) beinhaltet, die das aufrollbare Anzeigefeld aufnimmt.

6. Anzeigevorrichtung nach einem der vorhergehenden Ansprüche, wobei das aufrollbare Anzeigefeld ferner
beinhaltet:
eine erste Anschlussflächenelektrode (PE1), die das mindestens eine Loch in dem Nicht-Anzeigebereich in einer Draufsicht überlappt;
eine zweite Anschlussflächenelektrode (PE2), die auf der ersten Anschlussflächenelektrode angeordnet ist und die erste Anschlussflächenelektrode elektrisch kontaktiert; und
eine dritte Anschlussflächenelektrode (PE3), die auf der zweiten Anschlussflächenelektrode angeordnet ist und die zweite Anschlussflächenelektrode elektrisch kontaktiert, und
wobei das Leiterbild die dritte Anschlussflächenelektrode elektrisch kontaktiert.

7. Anzeigevorrichtung nach Anspruch 6, ferner umfassend:
ein Verbindungselement (250), das auf einer Oberfläche der ersten Anschlussflächenelektrode in dem mindestens einen Loch angeordnet ist und das Leiterbild und das Gehäuse elektrisch verbindet.

8. Anzeigevorrichtung nach Anspruch 7, wobei das Verbindungselement eine Paste ist, die ein leitendes Material beinhaltet.

9. Anzeigevorrichtung nach einem der vorhergehenden Ansprüche, wobei die Pixel so angeordnet sind, dass sie in einem Matrixformat voneinander beabstandet sind, und das Leiterbild eine Maschenform aufweist, die jedes der Pixel umgibt.

10. Anzeigevorrichtung nach einem der Ansprüche 1 bis 8, wobei die Pixel so angeordnet sind, dass sie in einem Matrixformat voneinander beabstandet sind, und das Leiterbild zwei oder mehr der Pixel umgibt.

11. Anzeigevorrichtung nach einem der vorhergehenden Ansprüche, wobei Kontaktflächen-Teile in dem Nicht-Anzeigebereich angeordnet sind und das mindestens eine Loch jeweils zwischen den Kontaktflächen-Teilen ausgebildet ist.

12. Anzeigevorrichtung nach Anspruch 4 oder einem der Ansprüche 5 bis 11, wenn abhängig von Anspruch 4, wobei die Anzeigevorrichtung ferner umfasst:
eine Farbumwandlungsschicht (CCL), die auf der Basisschicht in dem Anzeigebereich angeordnet ist und mindestens eine Art von Farbumwandlungspartikel beinhaltet;
wobei das Schwarzmatrixmuster auf beiden Seiten der Farbumwandlungsschicht angeordnet ist.

13. Anzeigevorrichtung nach Anspruch 12, ferner umfassend:
eine Planarisierungsschicht (PLL), die die Farbumwandlungsschicht und das Leiterbild bedeckt; und
eine Farbfilterschicht (CFL), die auf der Planarisierungsschicht angeordnet ist und einen Farbfilter (CF1, CF2, CF3) beinhaltet, der einer Farbe des Farbumwandlungspartikels entspricht.

14. Anzeigevorrichtung nach Anspruch 13, ferner umfassend:
ein oberes Substrat (UPC), das auf der Farbfilterschicht angeordnet ist.

## Revendications

1. Dispositif d'affichage (1000), comprenant :
un panneau d'affichage enroulable (100) qui comprend :
une zone d'affichage (DA) agencée pour afficher une image ; une zone de non affichage (NDA) ; et
une couche de base (BSL) comprenant au moins un trou (HOL) défini dans la zone de non affichage (NDA) ; et
un boîtier (200) relié au panneau d'affichage enroulable (100) et conçu pour recevoir le panneau d'affichage enroulable (100),
dans lequel le panneau d'affichage enroulable (100) comprend :
des pixels (PXL) disposés sur la zone d'affichage (DA) de la couche de base (BSL) ; et
un motif conducteur (CP) disposé sur la couche de base (BSL) entre les pixels (PXL) dans la zone d'affichage (DA) et chevauchant l'au moins un trou (HOL) dans une vue en plan, et
dans lequel le motif conducteur (CP) est relié électriquement au boîtier (200) à travers de l'au moins un trou (HOL).

2. Dispositif d'affichage de la revendication 1, dans lequel le motif conducteur comprend un matériau d'électrode transparent.

3. Dispositif d'affichage de la revendication 1, dans lequel le motif conducteur comprend un matériau polymère conducteur.

4. Dispositif d'affichage de la revendication 1, 2 ou 3, comprenant en outre :
un motif de matrice noire disposé entre les pixels dans la zone d'affichage,
dans lequel le motif conducteur chevauche le motif de matrice noire dans une vue en plan.

5. Dispositif d'affichage de l'une quelconque des revendications précédentes, dans lequel le boîtier comprend une rainure de boîtier (220) recevant le panneau d'affichage enroulable.

6. Dispositif d'affichage de l'une quelconque des revendications précédentes, dans lequel le panneau d'affichage enroulable comprend en outre :
une première électrode de plot (PE1) chevauchant l'au moins un trou dans la zone de non affichage dans une vue en plan ;
une deuxième électrode de plot (PE2) disposée sur la première électrode de plot et en contact électrique avec la première électrode de plot ; et
une troisième électrode de plot (PE3) disposée sur la deuxième électrode de plot et en contact électrique avec la deuxième électrode de plot, et
le motif conducteur en contact électrique avec la troisième électrode de plot.

7. Dispositif d'affichage de la revendication 6, comprenant en outre :
un élément de liaison (250) disposé sur une surface de la première électrode de plot dans l'au moins un trou et reliant électriquement le motif conducteur et le boîtier.

8. Dispositif d'affichage de la revendication 7, dans lequel l'élément de liaison est une pâte comprenant un matériau conducteur.

9. Dispositif d'affichage de l'une quelconque des revendications précédentes, dans lequel les pixels sont disposés pour être espacés les uns des autres dans un format de matrice, et
le motif conducteur présente une forme de maille entourant chacun des pixels.

10. Dispositif d'affichage de l'une quelconque des revendications 1 à 8, dans lequel les pixels sont disposés pour être espacés les uns des autres dans un format de matrice, et
le motif conducteur entoure deux des pixels ou plus.

11. Dispositif d'affichage de l'une quelconque des revendications précédentes, dans lequel des parties de plot sont disposées dans la zone de non affichage, et
l'au moins un trou est respectivement formé entre les parties de plot.

12. Dispositif d'affichage de la revendication 4 ou de l'une quelconque des revendications 5 à 11 lorsqu'elles dépendent de la revendication 4, dans lequel le dispositif d'affichage comprend en outre :
une couche de conversion de couleur (CCL) disposée sur la couche de base dans la zone d'affichage et comprenant au moins un type de particule de conversion de couleur ;
dans lequel le motif de matrice noire est disposé au niveau des deux côtés de la couche de conversion de couleur.

13. Dispositif d'affichage de la revendication 12, comprenant en outre :
une couche de planarisation (PLL) recouvrant la couche de conversion de couleur et le motif conducteur ; et
une couche de filtre de couleur (CFL) disposée sur la couche de planarisation et comprenant un filtre de couleur (CF1, CF2, CF3) correspondant à une couleur de la particule de conversion de couleur.

14. Dispositif d'affichage de la revendication 13, comprenant en outre :
un substrat supérieur (UPC) disposé sur la couche de filtre de couleur.
